# FASCICULE DE BREVET EUROPEEN

(11) **EP 2 132 684 B1**
(45) Date de publication et mention de la délivrance du brevet: **22.08.2012**
(21) Numéro de dépôt: 08708740.9
(22) Date de dépôt: 06.02.2008
(51) Int. Cl.: G06K 19/077, B42D 15/10

(54) **PROCEDE DE FABRICATION DE CARTES ELECTRONIQUES COMPRENANT AU MOINS UN MOTIF IMPRIME**
VERFAHREN ZUR HERSTELLUNG ELEKTRONISCHER KARTEN MIT MINDESTENS EINER DARAUF ANGEBRACHTEN STRUKTUR
METHOD FOR PRODUCING ELECTRONIC CARDS INCLUDING AT LEAST ONE PRINTED PATTERN

(30) Priorité: 09.02.2007 EP 07102087
(43) Date de publication de la demande: 16.12.2009
(73) Titulaire: NagraID S.A., 2301 La Chaux-de-Fonds (CH)
(72) Inventeur: DROZ, François, CH-2035 Corcelles (CH)
(74) Mandataire: Surmely, Gérard
(86) Numéro de dépôt international: PCT/EP2008/051447
(87) Numéro de publication internationale: WO 2008/101807

(56) Documents cités:
- WO-A-03/056500
- WO-A-03/090151
- WO-A-2004/068395
- WO-A-2004/074000
- US-A1- 2004 256 469

## Description

La présente invention concerne la fabrication de cartes électroniques, c'est-à-dire de cartes comprenant au moins une unité électronique et présentant un contour quelconque. Plus particulièrement, l'invention concerne la fabrication de telles cartes électroniques présentant au moins un motif imprimé qui est protégé par un revêtement au moins partiellement transparent, notamment par un film externe (overlay).

Dans un mode de mise en oeuvre particulier de l'invention, la carte fabriquée présente des motifs imprimés à ses deux faces planes, chaque motif imprimé étant protégé par un film au moins partiellement transparent.

On notera que le procédé selon l'invention s'applique à tous types de cartes électroniques ayant des épaisseurs diverses et également des dimensions variables. Toutefois, le procédé selon l'invention est particulièrement efficace et avantageux pour la fabrication de cartes électroniques ayant une épaisseur relativement faible, par exemple d'environ 0.8 millimètre, comme pour les cartes du type bancaire, ou présentant une épaisseur inférieure.

La présente invention concerne en particulier des cartes présentant des motifs imprimés de haute qualité, par exemple des cartes bancaires ou des cartes d'identité ayant une impression sécuritaire difficile à contrefaire.

On connaît du document WO 2004/074000 un procédé de fabrication de cartes où une écriture d'une information est réalisée par un faisceau laser après que les diverses couches de la carte aient été assemblées. Pour ce faire, une couche spécifique pouvant être écrite au laser est introduite dans la carte. Une telle méthode d'écriture d'un texte ou d'un motif est limitée et demande relativement beaucoup de temps puisque le faisceau laser doit suivre un tracé correspondant au motif prévu. Une telle méthode peut servir à des écritures de personnalisation de cartes. Par contre, elle ne permet pas de réaliser des motifs de diverses couleurs ou couvrant entièrement une certaine surface de la carte. De plus, cette technique requiert l'intégration d'une couche spécifique sensible au laser dans la carte. Ainsi, cette technique d'écriture laser n'entre pas dans le cadre de la présente invention qui concerne des techniques d'impression avec des encres déposées sur des surfaces de feuilles ou de couches solides formant les cartes fabriquées.

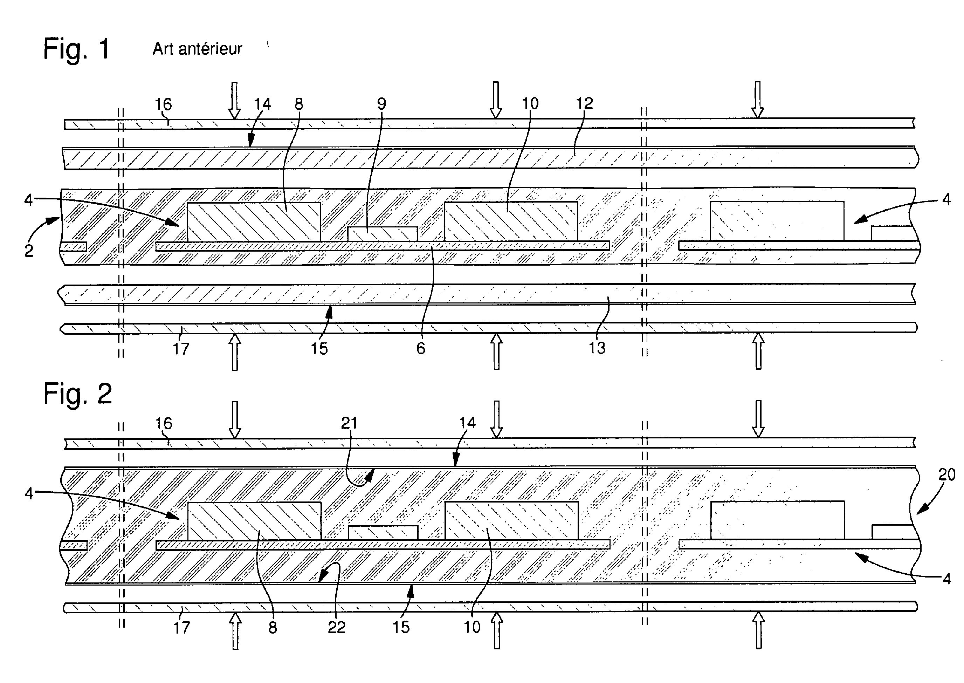

A l'aide de la figure 1 jointe à la présente description, on décrira ci-après le procédé classique de fabrication de cartes électroniques présentant des motifs imprimés avec une encre des deux côtés de la carte. On peut distinguer trois étapes principales dans ce procédé classique. Premièrement, une couche interne 2 (inlay) comprenant une pluralité de modules électroniques 4 est formée. Le module électronique 4 est formé d'un substrat 6 supportant divers éléments électroniques 8, 9 et 10. On notera que le module électronique peut être quelconque et formé par exemple d'éléments électroniques reliés les uns aux autres sans substrat. Ensuite, on fournit deux couches intermédiaires opaques 12 et 13 sur lesquelles on imprime respectivement des premiers et deuxièmes motifs 14 et 15. Pour obtenir des impressions de bonne qualité, les couches intermédiaires sont de préférence blanches. De plus, pour assurer une bonne stabilité de ces couches intermédiaires lors de l'impression des premiers et deuxièmes motifs, l'homme du métier sélectionne par exemple des feuilles PVC ayant une épaisseur suffisante, en général supérieure à 100 microns. Pour obtenir une carte avec des impressions à haute définition, en particulier du type carte d'identité, l'homme du métier sélectionne des couches intermédiaires ayant une épaisseur de préférence située entre 120 et 150 microns. Finalement, on apporte deux couches externes transparentes (overlay) 16 et 17 sur les motifs imprimés et on place la couche interne 2, les deux couches intermédiaires 12 et 13 et les deux couches externes 16 et 17 dans une installation de laminage (symbolisée par les flèches verticales) pour assembler ces diverses couches et réaliser ainsi une plaque définissant une pluralité de cartes électroniques imprimées. Les cartes individuelles sont obtenues par un découpage terminal dans cette plaque. Un procédé de fabrication de cartes similaire à celui décrit ci-avant est décrit dans la publication US 2004/0256469.

Les couches transparentes 16 et 17 présentent en général une épaisseur située entre 50 et 100 microns, de préférence entre 60 et 80 microns.

Dans le cas usuel de cartes du type bancaire ayant une épaisseur de 0.76 à 0.84 mm selon la norme ISO, on constate que l'épaisseur totale des couches intermédiaires et des couches externes de protection s'élève, à titre d'exemple, à 360 microns (0.36 millimètre) en choisissant des couches intermédiaires ayant une épaisseur de 120 microns et des couches externes ayant une épaisseur de 60 microns. Ainsi, pour obtenir des cartes dans la norme ISO susmentionnée, la couche interne comprenant les unités électroniques doit présenter une épaisseur inférieure à 480 microns, à savoir entre 400 et 480 microns.

Comme la hauteur de la couche interne 2 est limitée, la hauteur des éléments électroniques pouvant être incorporés dans cette couche 2 est également limitée. Dans le cas où la carte électronique incorpore au moins un élément électronique d'une hauteur par exemple d'environ 300 microns, l'épaisseur du matériau formant la couche interne est donc faible au-dessus et au-dessous de cet élément électronique. On observe qu'il est difficile dans ces conditions d'obtenir une couche interne ayant des surfaces bien planes et présentant un comportement homogène en présence de chaleur. Ainsi, lors de l'étape de laminage du procédé classique décrit ici, les couches intermédiaires subiront facilement des déformations locales dans les zones superposées aux éléments électroniques. Le fait que la couche interne 2 présente souvent des ondulations en surface nécessite un apport d'énergie thermique relativement important de manière à diminuer au mieux ces ondulations lors du laminage. La compensation de ces ondulations et de déformations de la couche interne sous l'effet de la chaleur engendre des déformations des couches intermédiaires qui, de par leur positionnement dans le multicouche laminé, sont ramollies et subissent facilement de telles déformations, voir un certain étalement. Ces couches intermédiaires recevant en effet plus d'énergie thermique que la couche interne et ayant une épaisseur inférieure à cette couche interne, elles subissent généralement les déformations les plus importantes. Etant donné que ces couches intermédiaires 12 et 13 supportent les motifs imprimés, ces derniers sont facilement détériorés lors de l'étape de laminage final.

On remarquera que les déformations locales, dans les zones où sont situés les éléments électroniques, sont notamment engendrées par des comportements différents des matériaux formant la couche interne 2 en présence de chaleur, ce qui affecte l'état de surface de la couche interne étant donné la faible épaisseur dudit matériau dans ces zones lorsque les éléments électroniques sont proches des faces de cette couche interne. Ainsi, lors de l'étape de laminage où une énergie thermique est apportée pour assembler les diverses couches, le comportement de la matière dans les zones où sont situés les éléments électroniques et les bossages éventuels dus à la présence de ces éléments électroniques engendrent de petits déplacements de matière de manière localisée dans les couches intermédiaires ramollies, ce qui entraîne alors un marquage des motifs imprimés sur ces couches intermédiaires. Finalement, on mentionnera encore la dureté supérieure des éléments électroniques qui marquent aussi facilement les couches intermédiaires lors du laminage lorsque ces couches intermédiaires sont situées à faible distance de ces éléments électroniques.

Le procédé de fabrication classique décrit ci-avant permet de réaliser la couche interne incorporant les unités ou modules électroniques dans des presses à surfaces planes et donc de ne pas cintrer ces unités ou modules électroniques lors de la fabrication des cartes. L'homme du métier considère ce fait comme un élément essentiel du procédé de fabrication de cartes électroniques, notamment lorsque les unités ou modules électroniques présentent des dimensions relativement grandes et/ou des connexions électriques entre divers éléments électroniques. Il évitera ainsi de cintrer ou d'incurver la couche interne ou feuille centrale 2 tout au long du procédé de fabrication de cartes.

Ensuite, l'homme du métier considère le procédé classique susmentionné comme approprié pour obtenir une impression de qualité de chaque côté de la carte. En effet, les couches intermédiaires opaques définissent une surface plane et un support d'impression homogène. De plus, l'homme du métier considère qu'il est nécessaire d'utiliser de telles couches intermédiaires pour recevoir un motif imprimé à haute définition, en particulier lorsqu'il utilise à cet effet une installation d'impression à cylindres, notamment du type Offset. Comme le support d'impression est tendu sur les surfaces cylindriques des cylindres, l'homme du métier prévoit, d'une part, de fabriquer la couche interne (inlay) incorporant les éléments électroniques et, d'autre part, de réaliser séparément l'impression de haute qualité sur une couche uniforme entièrement formée par un matériau plastique, par exemple une feuille PVC. Ensuite, il assemble ces couches dans une installation de laminage où ces couches sont pressées entre des surfaces planes pour être assemblées.

On constate donc que l'homme du métier tend naturellement à utiliser des feuilles plastiques homogènes, d'une épaisseur d'environ 100 à 150 microns, comme support pour une impression de qualité, notamment du type Offset. Il sait que de telles feuilles se comportent correctement dans les installations d'impression à cylindres. Ainsi, il sépare la formation de la couche interne incorporant les éléments électroniques et l'impression sur des supports homogènes et flexibles. Ensuite, il assemble ces couches dans une technique à plat pour obtenir des cartes électroniques présentant des motifs imprimés visibles de chaque côté des cartes. Les couches intermédiaires servant de support d'impression doivent de préférence avoir une certaine épaisseur pour, d'une part, assurer une stabilité du support dans l'installation d'impression et, d'autre part, limiter l'étalement de ces couches intermédiaires lors de l'étape de laminage ultérieur.

Ainsi, comme cela a déjà été mentionné, le procédé classique utilisé par l'homme du métier présente un premier inconvénient dû à l'épaisseur limitée de la couche interne 2; ce qui limite la hauteur des éléments électroniques incorporés et engendre des déformations au niveau des couches intermédiaires imprimées lors du passage dans la presse à chaud utilisée pour former la carte terminée.

On notera de manière non exhaustive encore d'autres inconvénients du procédé classique décrit ci-avant. Le laminage d'un multicouche formé d'une couche interne d'une épaisseur inférieure à 500 microns, de deux couches intermédiaires ayant chacune une épaisseur d'au moins 100 microns et de deux couches externes transparentes ayant une épaisseur de 60 à 80 microns requiert d'utiliser une installation de laminage relativement onéreuse. De plus, étant donné que la couche interne 2 peut présenter une légère ondulation de surface et des tensions internes dans le matériau qui la forme, le laminage de ces diverses couches nécessite une bonne maîtrise du procédé de fabrication de cartes, notamment pour régler les paramètres intervenant dans ce procédé, à savoir la pression, la température et la durée du cycle de laminage. Etant donné le savoir-faire important nécessaire à la réalisation de cartes de bonne qualité, l'étape de laminage est effectuée de préférence par un spécialiste de telles techniques. On constate donc que, outre le fait qu'il est très difficile d'obtenir des cartes avec des motifs imprimés à haute définition sans détériorations locales, la fabrication de telles cartes doit être réalisée chez un producteur spécialisé si l'on souhaite obtenir des cartes de haute qualité. Ainsi, la flexibilité dans la finition des cartes, que l'on pourrait attendre de la fabrication séparée des couches internes incorporant les éléments électroniques et des couches intermédiaires imprimées dans des installations d'impression de feuilles plastiques, ne peut être exploitée en pratique. Par conséquent, il est guère envisageable de prévoir d'effectuer au moins partiellement l'impression et l'assemblage final des cartes de manière délocalisée chez un distributeur ou un utilisateur des cartes.

Un but de la présente invention est de proposer un procédé de fabrication de cartes électroniques qui pallie les divers inconvénients de l'art antérieur mentionnés ci-avant, en proposant une solution rationnelle permettant d'obtenir des cartes électroniques avec des motifs imprimés de très bonne qualité, notamment à haute définition, par un procédé efficace.

Un autre but de l'invention est de fournir un procédé de fabrication de cartes ayant un motif sécuritaire présentant une haute définition et un motif personnalisé pouvant avoir une moindre définition; ce procédé permettant d'effectuer aisément de manière délocalisée l'impression du motif personnalisé et la finalisation des cartes pour assurer la protection de ce motif personnalisé par l'apport d'un revêtement au moins partiellement transparent.

A cet effet, l'invention concerne un procédé de fabrication de cartes selon la revendication 1 comprenant chacune au moins une unité électronique incorporée dans un corps de carte et au moins un premier motif imprimé du côté d'une première face de ce corps de carte, ce procédé comportant les étapes suivantes :
A) Formation d'une pluralité de corps de carte sous forme d'une feuille épaisse dans laquelle est incorporée respectivement une pluralité d'unités électroniques ;
B) Impression d'une pluralité de premiers motifs sur une première face de ladite feuille épaisse dans une installation d'impression dans laquelle une encre est déposée sur ladite première face pour réaliser cette pluralité de premiers motifs respectivement sur ladite pluralité de corps de carte;
C) Apport d'un revêtement au moins partiellement transparent sur chaque premier motif imprimé de manière qu'il adhère audit corps de carte respectif.

Dans un mode de mise en oeuvre principal de ce procédé, il est également prévu d'effectuer aussi une impression d'une pluralité de deuxièmes motifs sur la seconde face de la feuille épaisse dans une installation d'impression, dans laquelle une encre est déposée sur cette seconde face, et d'apporter un revêtement au moins partiellement transparent sur chaque deuxième motif imprimé et adhérant audit corps de carte. Dans ce cas, l'apport des premier et deuxième revêtements, en particulier de deux films plastiques, est effectué simultanément après avoir effectué l'impression des premiers et deuxièmes motifs. Le revêtement peut aussi être formé par une laque ou une encre transparente déposée par transfert depuis un support de cette encre. Dans ce dernier cas, la laque ou l'encre transparente est déposée de préférence directement après l'impression de chaque face.

Selon une variante préférée, ladite feuille épaisse, qui forme la pluralité de corps de carte où sont incorporés les unités ou modules électroniques respectifs, présente une épaisseur sensiblement égale ou supérieure aux deux tiers de l'épaisseur finale des cartes fabriquées. En particulier, dans le cas de cartes ayant une épaisseur ISO comprise entre 0.76 et 0.84 mm, l'épaisseur de ladite feuille épaisse imprimée est de préférence sensiblement égale ou supérieure à 0.60 mm (600 microns) et les deux revêtements sont formés respectivement par deux films externes.

Selon un mode de mise en oeuvre préféré du procédé selon l'invention, l'installation d'impression utilisée pour imprimer ladite pluralité de premiers motifs sur une première face de la feuille épaisse est formée de plusieurs cylindres servant de supports d'impression. Ainsi, la feuille épaisse incorporant la pluralité d'unités ou modules électroniques est agencée successivement sur les surfaces de ces cylindres lors de l'étape d'impression. Les feuilles épaisses sont donc incurvées ou cintrées dans l'installation d'impression, ce que l'homme du métier évite généralement. En particulier, l'installation d'impression est une installation d'impression Offset ou similaire permettant de réaliser des impressions à haute définition.

On remarquera qu'il est possible de prévoir plusieurs impressions successives sur les faces de la feuille épaisse. Par exemple, on effectue premièrement l'impression d'un premier motif à haute définition sur la première face de la feuille épaisse, notamment un motif sécuritaire, c'est-à-dire difficilement reproductibles sans moyens importants. Ensuite, on effectue ultérieurement, notamment dans une installation du Client, une deuxième impression, en général de moindre définition mais pas nécessairement, directement sur la première impression ou sur une fine couche intermédiaire au moins partiellement transparente agencée sur la première impression. Cette deuxième impression peut définir des données personnelles.

On remarquera que les impressions ultérieures aux premiers motifs peuvent être effectuées sur la feuille épaisse ou sur chaque corps de carte après une étape de découpage de ce corps de carte dans cette feuille. Dans ce dernier cas le revêtement est apporté sur les motifs imprimés de chaque corps de carte individuel pour finir la fabrication dans une installation carte à carte.

De manière générale, dans le procédé selon l'invention ou dans un quelconque procédé de fabrication de cartes en lot à partir d'une plaque (avec ou sans éléments électroniques incorporés dans la plaque), on prévoit un procédé avantageux pour imprimer individuellement chaque carte et recouvrir ensuite les impressions de cette carte par un film plastique externe d'une certaine épaisseur (overlay) qui est le suivant : Chaque corps de carte, comprenant on non déjà un premier motif imprimé, est découpée dans la plaque avec un contour initial aux dimensions supérieures à celles de la carte finie. Ensuite au moins une impression particulière est imprimée sur chaque corps de carte et un film externe d'une épaisseur par exemple de 40 à 80 microns est apporté dessus, avec ou sans fine couche de résine, et assemblé carte à carte sous une petite presse adaptée au format supérieur de ces corps de carte. Finalement, on effectue un découpage du contour final de la carte à l'intérieur dudit contour initial. Ceci permet une fabrication individuelle des cartes dans une deuxième phase individuelle du procédé de fabrication, tout en ayant un film externe laminé avec le corps de carte et un bord de carte bien net avec une tranche uniforme, donc une carte de bonne qualité.

Dans un mode de mise en oeuvre le procédé comporte en outre, avant ladite étape C), l'étape suivante :
D) Impression d'une pluralité de troisièmes motifs sur une face dudit film ou sur des faces respectives de ladite pluralité de films ;
   et en ce que ladite étape C) est mise en oeuvre par les deux sous-étapes suivantes :
   C1) Agencement dudit film ou de ladite pluralité de films du côté de ladite première face de ladite feuille épaisse, chaque troisième motif étant situé au-dessus d'un corps de carte différent, ou, dans le cas où une étape de découpage des corps de carte dans ladite feuille épaisse intervient suite à ladite étape B), de ladite pluralité de films sur ladite pluralité respective de corps de carte découpés, de manière que la face imprimée de ce film ou de ces films soit située du côté de ladite pluralité de corps de carte et que lesdits premiers motifs soient au moins partiellement visibles au travers dudit film ou desdits films ; et
   C2) Assemblage de ladite feuille épaisse avec ledit film ou ladite pluralité de films ou de chaque corps de carte découpé avec un desdits films. découpage des corps de carte dans ladite feuille épaisse, de ladite pluralité de films sur ladite pluralité respective de corps de carte, de manière que la face imprimée de ce film ou de ces films soit située du côté de cette feuille épaisse ou que la face imprimée d'une partie dudit film ou d'un desdits films soit située du côté d'un corps de carte respectif et que lesdits premiers motifs soient au moins partiellement visibles au travers dudit film ou desdits films ; et
E) Assemblage de ladite feuille épaisse avec ledit film ou ladite pluralité de films ou de chaque corps de carte avec une partie dudit film ou un desdits films.

Tout en conservant les avantages de l'invention déjà décrits, ce procédé constitue un perfectionnement qui permet de réaliser des impressions complexes, en particulier d'un motif sécuritaire à haute définition formant une impression générale de base sur laquelle ou au-dessus de laquelle est agencé un deuxième motif imprimé sur un support différent, par exemple un motif personnalisé comme cela intervient dans des cartes bancaires ou des cartes d'identité. Ce procédé de fabrication perfectionné permet ainsi de superposer aisément un motif personnalisé et un motif sécuritaire à haute définition, notamment quasi imperceptible à l'oeil nu.

Par motif personnalisé ou données personnelles, on comprend toute impression ayant un caractère variable en fonction de sa destination, que ce soit notamment une société, une personne, un animal ou un objet. Cette impression personnalisée peut être un numéro et/ou une photo, un logo, une marque, etc.

L'étape de découpage des cartes individuelles peut intervenir avant l'étape D) ou après l'étape E). Les étapes D) et E) peuvent être quasi simultanées ou même simultanées si le film est mis en contact avec le corps de carte par la presse d'assemblage. Ainsi, on peut travailler en plaque jusqu'à un découpage terminale des cartes ou finir les cartes une à une en assemblant chaque corps de carte avec un film transparent respectif. On peut même envisager une installation avec une pluralité de motifs imprimés sur un même film et chaque corps de carte (déjà découpé) apporté individuellement en regard d'une partie de ce film comportant un motif imprimé qui est destiné à ce corps de carte. Ensuite, par exemple une presse à chaud peut être utilisée pour assembler ladite partie du film avec le corps de carte individuel et seulement ensuite la partie du film est découpée dans celui-ci. On peut donc effectuer un travail en continu en utilisant un film sous forme de bande, comme un film photographique. De préférence, un découpage du contour final de chaque carte est effectué dans chaque corps de carte qui présente alors des dimensions supérieures à celle de la carte finie.

Selon une variante préférée, il est prévu, après l'étape d'impression B), de recouvrir ladite première face imprimée d'un film de protection ou d'une laque de manière à protéger, avant l'étape D), lesdits premiers motifs imprimés.

Selon une première variante particulière, ledit film de protection ou ladite laque sont agencés de manière amovible à la première face imprimée de la feuille épaisse et sont enlevés avant l'étape D) où le(s) film(s) au moins partiellement transparent(s) est (sont) agencé(s) sur cette première face imprimée. Ces caractéristiques permettent d'assurer la protection des premiers motifs imprimés jusqu'au moment où le(s) film(s) au moins partiellement transparent(s), comprenant l'impression des deuxièmes motifs, est (sont) apporté(s) au-dessus de la première face imprimée de la feuille épaisse. Cette feuille épaisse peut ainsi être stockée et/ou transportée après l'impression sans risquer de détériorer les motifs imprimés. Ceci est particulièrement important lorsque les premiers motifs imprimés définissent des impressions sécuritaires à haute définition.

Selon une autre variante spécifique, le film de protection ou la laque recouvrant la première face de la feuille épaisse adhère correctement à cette dernière et sont sélectionnés de manière à former une interface d'adhérence entre le film ou les films au moins partiellement transparent(s) et la feuille épaisse lors de l'assemblage à l'étape E). On obtient ainsi les mêmes bénéfices que dans l'autre variante spécifique décrite ci-avant, mais le film de protection ou la laque font partie des cartes fabriquées et sont donc prévues au moins partiellement transparentes.

Pour certaines applications particulières et certains marchés, notamment celui de la carte d'identité, le procédé perfectionné selon l'invention permet aisément de réaliser les étapes B) et D) dans des sites de production différents pouvant notamment être situés dans des pays différents. Ainsi, par exemple, le premier motif imprimé sur la feuille épaisse définit une impression sécuritaire générale nécessitant des équipements onéreux et une très bonne maîtrise des techniques d'impression, alors que le deuxième motif imprimé sur le film transparent définit une impression personnalisée pouvant avoir une moindre définition et être imprimée dans un pays de destination à l'aide de moyens moins onéreux et requérant un moindre savoir-faire.

Avantageusement, le procédé perfectionné selon l'invention permet de laminer deux films externes au moins partiellement transparent avec la feuille épaisse, imprimée notamment recto et verso, par un faible apport d'énergie relativement à la quantité d'énergie utilisée généralement dans l'étape A); ce qui permet de limiter les déformations de la feuille épaisse et même d'empêcher toutes déformations perceptibles dans les premiers motifs imprimés. Toutefois, étant donné la stabilité supérieure de la feuille épaisse, on peut envisager en particulier une fabrication avec une apport de chaleur comme dans l'art antérieur tout en obtenant peu ou pas de déformation. Ceci est à prévoir notamment lorsqu'un empilement de plaques est agencé dans une presse à chaud, pour permettre à la chaleur d'atteindre les plaques médianes.

Comme dans le procédé selon l'invention mentionné en premier, de manière surprenante pour l'homme de métier qui n'aurait pas envisagé une telle manière de fabriquer des cartes électroniques avec un motif imprimé de très bonne qualité, il est prévu dans un mode de mise en oeuvre préféré que l'installation d'impression des premiers motifs soit formée de plusieurs cylindres servant de support d'impression, la feuille épaisse incorporant la pluralité d'unités électroniques étant agencée successivement à la surface de ces cylindres lors de l'étape d'impression et étant ainsi incurvée à plusieurs reprises dans cette installation d'impression. Divers tests ont démontré de manière étonnante que des unités ou modules électroniques noyés dans une feuille épaisse relativement flexible peuvent dans plusieurs cas passer au travers d'une telle installation d'impression sans que les unités ou modules électroniques ne soient endommagés. Lorsque certains éléments électroniques présentent des dimensions importantes, on veillera à donner si possible à ces éléments une certaine souplesse et capacité de déformation élastique. Des précautions au niveau des liaisons et connexions électriques entre éléments électroniques peuvent s'avérer nécessaires. En particulier, on favorisera les supports souples et des contacts électriques glissants.

De préférence, l'installation d'impression prévue pour les premiers motifs est une installation d'impression Offset ou similaire permettant de réaliser des impressions à haute définition.

Selon une variante de mise en oeuvre, il est également prévu d'effectuer l'impression d'une pluralité de troisièmes motifs sur la seconde face de la feuille épaisse dans une installation d'impression, et d'apporter ensuite un revêtement au moins partiellement transparent sur chaque troisième motif imprimé et adhérant aux corps de carte formés par ladite feuille épaisse. De préférence, l'apport des premier et deuxième films et leur assemblage sont effectués au cours d'une même étape après avoir effectuer les diverses impressions prévues.

Comme dans le procédé selon l'invention mentionné en premier, ladite feuille épaisse, dans une variante préférée, présente une épaisseur sensiblement égale ou supérieure au deux tiers de l'épaisseur finale des cartes fabriquées. Dans le cas particulier des cartes du type bancaire, la feuille épaisse imprimée présente de préférence une épaisseur sensiblement égale ou supérieure à 0.60 mm.

De manière générale, il est possible de prévoir une fine couche de résine déposée ou agencée soit sur la première, respectivement deuxième face imprimée de la feuille épaisse, soit sur la face imprimée du film au moins partiellement transparent apportée sur l'une de ces deux faces. Cette fine couche de résine est sélectionnée de manière à former une interface d'adhérence entre le film et la feuille épaisse. En général, cette fine couche de résine est agencée sur le motif imprimé. Toutefois, dans une variante, il est possible de déposer premièrement la fine couche de résine sur la face du support considéré et d'effectuer sur cette résine l'impression prévue. Cette dernière variante est toutefois délicate étant donné qu'il est difficile d'éviter alors un certain étalement des encres lors de l'étape d'assemblage, en particulier par laminage ou une certaine quantité d'énergie thermique est transmise à la fine couche de résine.

Le procédé selon l'invention présente plusieurs avantages. Premièrement il permet d'obtenir des Inlays incorporant des unités électroniques plus épais que dans l'art antérieur pour la fabrication de cartes présentant au moins un motif imprimé de qualité protégé par un revêtement transparent. On peut distinguer deux cas différents où la feuille épaisse selon l'invention apporte un avantage important. Dans un premier cas, un corps de carte présentant une épaisseur supérieure permet d'incorporer des éléments électroniques plus haut que ceux pouvant être intégrés dans un procédé de l'art antérieur. Dans le second cas, pour une unité ou un module électronique donné, la quantité de matière recouvrant les faces supérieure et inférieure des éléments électroniques est plus importante que dans le cas d'un procédé selon l'art antérieur. Ainsi, l'épaisseur du matériau formant la couche épaisse au-dessus et au-dessous des éléments électroniques est supérieure, ce qui permet d'obtenir plus aisément un état de surface parfaitement plat pour effectuer une impression de qualité. En effet, la planéité de la feuille imprimée est importante pour obtenir une parfaite reproduction du motif imprimé.

Comme déjà évoqué, lorsque l'épaisseur de la matière recouvrant les éléments électroniques est trop faible, les éléments électroniques engendrent généralement une certaine ondulation en surface du corps de carte. Ceci est particulièrement le cas lorsque la feuille définissant les corps de carte est obtenue par pression d'au moins deux feuilles plastiques entres lesquelles les éléments électroniques ont été placés. Lors de la pénétration de ces éléments électroniques dans les couches plastiques ramollies, le matériau se déforme pour permettre aux éléments électroniques d'être logés dans ces couches plastiques, ce qui engendre des tensions internes dans la matière formant ces couches. Lorsque les feuilles formant les corps de carte sont retirées de la presse, un léger bossage risque d'apparaître dans les zones où sont situés les éléments électroniques et ceci d'autant plus que l'épaisseur de matière recouvrant les éléments électroniques est faible.

Le procédé selon l'invention permet donc d'augmenter cette épaisseur de matière de recouvrement des éléments électroniques et d'obtenir un meilleur état de surface de la feuille épaisse qui présente alors une très bonne planéité et forme un bon support d'impression. De plus, cette feuille épaisse restera plus stable lors de l'étape d'assemblage finale avec les films externes au moins partiellement transparent. Cet avantage majeur est encore renforcé par un autre avantage majeur des procédés selon l'invention, à savoir que l'étape d'assemblage après les étapes d'impression consiste seulement à assembler la feuille épaisse formant, les corps de carte, à des films externes relativement minces. Cet assemblage peut donc être réalisé par un laminage à relativement faible température et d'une durée relativement courte, c'est-à-dire avec un apport d'énergie limité.

Les feuilles externes sont généralement stabilisées par les surfaces de la presse et la seule couche centrale est formée par la feuille épaisse qui ne subira pas de déformations perceptibles avec le faible apport d'énergie nécessaire à cette étape de laminage finale. Ce dernier avantage est déjà pour lui-même très important relativement au procédé de l'art antérieur qui nécessitait un apport d'énergie plus important étant donné la présence des deux feuilles intermédiaires servant de support d'impression. Ainsi, le fait d'imprimer directement sur la feuille incorporant les éléments électroniques qui, dans le cadre de l'invention, présente une épaisseur supérieure permet de s'affranchir des deux couches intermédiaires imprimées séparément et permet en plus d'assurer que la qualité des motifs imprimés ne soit pas diminuée lors de l'étape d'assemblage finale où ces motifs imprimés sont protégés par un film externe transparent.

Un autre avantage important concerne la fabrication de cartes ayant des impressions recto-verso. Comme le premier motif et le deuxième motif sont imprimés de part et d'autre de la feuille épaisse, il est relativement aisé d'assurer un positionnement relatif de ces deux motifs. De plus, lors de l'assemblage final, ce positionnement restera stable. Ceci n'est pas le cas dans l'art antérieur où les deux motifs sont imprimés respectivement sur deux couches intermédiaires nécessitant un positionnement relatif précis lors de l'étape d'assemblage finale, positionnement relatif qui peut varier lors de cette étape d'assemblage étant donné que les feuilles intermédiaires peuvent bouger assez aisément vu leur agencement entre la couche interne et les couches externes transparentes.

On notera encore un avantage intéressant découlant de l'invention: Pour permettre de laminer correctement des couches en matière plastique, l'homme du métier sélectionne de préférence des couches à surfaces mates, c'est-à-dire présentant un micro relief. Ainsi, dans le procédé de l'art antérieur décrit en introduction, l'impression est réalisée généralement sur de telles feuilles plastiques mates. Cet état de surface limite la définition possible pour le motif imprimé. Par contre, dans le cadre de la présente invention, lorsque le premier motif est imprimé sur la feuille épaisse, celle-ci peut présenter des surfaces plus lisses. Il suffit que cette feuille épaisse soit réalisée, au moins dans une étape finale, dans une presse présentant des surfaces lisses. La feuille épaisse résultante des procédés selon l'invention peut donc être parfaitement plane et lisse, ce qui permet d'imprimer des caractères ou motifs très fins et très petits, c'est-à-dire d'obtenir une impression ayant une haute définition.

Dans le cadre du procédé perfectionné, l'invention est très avantageuse car on fabrique premièrement une couche épaisse incorporant les éléments électroniques. Comme mentionné ci-avant, cette couche épaisse peut présenter des surfaces planes et uniformes. De plus, cette couche épaisse est stable car elle présente un minimum de tensions internes résiduelles relativement aux couches internes de l'art antérieur. Ainsi, cette couche épaisse forme un très bon support pour une impression à haute définition par le producteur de cartes ou un spécialiste de l'impression. On obtient donc une feuille épaisse incorporant les éléments électroniques et présentant notamment à ses deux faces des motifs imprimés de très bonne qualité, en particulier au moins un motif sécuritaire. Pour obtenir des cartes finies, il ne manque à cette feuille épaisse imprimée que des revêtements de protection transparents. Des films transparents peuvent être imprimés dans une installation relativement simple et peu onéreuse et être assemblés ensuite aisément avec la feuille épaisse, notamment par un faible apport d'énergie ; ce qui garantit de ne pas détériorer les motifs imprimés lors de cet assemblage final. L'impression sur les films transparents externes et l'assemblage de ceux-ci à la feuille épaisse peut donc être effectué à l'aide d'installations moins complexes et onéreuses et par un personnel moins qualifié. Ces étapes peuvent notamment être réalisées de manière délocalisées par le client avec des installations qui lui sont propres.

En résumé, le fait d'avoir, lors du laminage ou du collage final après impression, seulement une feuille épaisse centrale, qui ne se déforme pas localement ou globalement en présence d'un faible apport d'énergie, et deux couches externes relativement minces entre lesquelles est agencée cette feuille constitue un avantage majeur permettant de garantir la fabrication de cartes présentant des impressions de très bonne qualité qui ne risquent pas d'être détériorées lors dudit laminage ou collage final. Ceci permet d'augmenter le rendement industriel et également de délocaliser les impressions sur les films externes transparents et leur assemblage à la feuille épaisse centrale dans des sites de production différents de ceux où sont réalisés la feuille épaisse et les impressions de haute qualité sur ses faces.

L'invention a aussi pour objet un produit intermédiaire ou produit semi-fini selon la revendication 22 intervenant dans la fabrication de cartes selon l'invention. Ce produit intermédiaire est formé par une feuille incorporant une pluralité d'unités électroniques et définissant une pluralité respective de corps de carte, cette feuille présentant sur une première face une pluralité de premiers motifs imprimés.

Dans une variante avantageuse, ladite pluralité de premiers motifs est recouverte par un revêtement de protection, en particulier par un film plastique, une couche de résine ou une laque. A noter que la laque peut être par exemple une sorte d'encre transparente déposée à l'aide d'un film de transfert.

Dans un premier cas, le revêtement de protection est agencé temporairement sur la feuille épaisse. Il est ainsi peu adhérant à cette feuille et donc amovible.

Dans un second cas, le revêtement de protection adhère solidement à ladite feuille et est donc destiné à former une couche au moins partiellement transparente des cartes fabriquées à partir de ce produit intermédiaire.

Dans une variante particulière, les premiers motifs définissent des motifs sécuritaires à haute définition, notamment des éléments ou caractères d'impression quasi imperceptibles à l'oeil nu.

L'invention concerne finalement une plaque selon la revendication 28 obtenue lors de la mise en oeuvre du procédé perfectionné de l'invention. Cette plaque comprend une feuille ou couche épaisse incorporant une pluralité d'unités électroniques et définissant une pluralité respective de corps de carte, cette feuille présentant sur une première face une pluralité de premiers motifs imprimés. Cette plaque comprend en outre un premier film au moins partiellement transparent agencé à ladite première face de ladite feuille ou couche épaisse et présente une pluralité de deuxièmes motifs imprimés sur sa surface interne, chaque corps de carte étant associé à un premier motif et un deuxième motif qui sont situés sensiblement à un même niveau de la carte.

Dans une variante particulière, ladite pluralité de premiers motifs et ladite pluralité de deuxièmes motifs sont séparés l'une de l'autre par une fine couche au moins partiellement transparente formant une interface d'adhérence.

Dans une variante préférée, les premiers motifs définissent des motifs sécuritaires à haute définition et les deuxièmes motifs définissent au moins en partie des données personnelles.

Dans une autre variante, la plaque présente du côté de sa seconde face au moins une pluralité de troisième motifs imprimés protégée par un revêtement au moins partiellement transparent.

La présente invention sera encore décrite ci-après à l'aide du dessin annexé, donné à titre d'exemples nullement limitatifs, dans lequel:
- la figure 1, déjà décrite, représente schématiquement un procédé de fabrication de cartes selon l'art antérieur et comprenant des motifs imprimés recto-verso;
- la figure 2 représente schématiquement un premier mode de mise en oeuvre du procédé de fabrication de cartes selon l'invention;
- la figure 3 montre un mode de réalisation avantageux d'une feuille épaisse incorporant une pluralité d'unités électroniques ;
- la figure 4 représente de manière schématique un deuxième mode de mise en oeuvre du procédé de fabrication de cartes selon l'invention.
- les figures 5 et 6 montrent schématiquement une installation d'impression Offset utilisée de préférence pour imprimer les feuilles épaisses selon l'invention.

Le premier mode de mise en oeuvre du procédé selon l'invention représenté à la figure 2 se caractérise par le fait qu'une feuille épaisse 20, dans laquelle est incorporée une pluralité d'unités électroniques 4, est premièrement formée. Cette feuille épaisse 20 définit une pluralité de corps de carte comprenant chacun une unité électronique 4.

La feuille épaisse 20 peut être réalisée par toute technique connue de l'homme du métier, notamment en utilisant plusieurs couches laminées ou collées ensemble. Dans une variante au moins une couche centrale présente des ouvertures dans lesquelles sont logées au moins les éléments électroniques 8 et 10. Dans une autre variante, l'incorporation de l'unité électronique 4 est effectuée dans une presse où des couches plastiques sont premièrement ramollies suffisamment et sont ensuite pressées de manière contrôlée pour que l'unité électronique 4 pénètre dans ces couches de manière à former son propre logement. La feuille épaisse 20 peut dans une autre variante être obtenue par coulage ou injection d'une résine liquide.

De préférence, les surfaces planes 21 et 22 de la couche épaisse 20 sont opaques, en particulier blanches. Cependant certaines zones de ces surfaces peuvent présenter d'autres couleurs ou être transparentes pour laisser apparaître à un niveau inférieur un affichage quelconque, un logo ou un hologramme. Une impression partielle sur de telles zones transparentes est envisageable, notamment à des fins sécuritaires.

Lors de la formation de la couche épaisse 20, il est prévu d'obtenir des surfaces 21 et 22 présentant une très bonne planéité et, de préférence, un aspect lisse. Comme la feuille épaisse 20 présente une épaisseur supérieure à celle de la couche interne de l'art antérieur représentée à la figure 1, la présence du module électronique 4 à l'intérieur de la couche 20 affecte peu l'état des surfaces 21 et 22 si l'homme du métier maîtrise correctement la technologie utilisée pour la formation de cette couche 20. On remarquera en effet que l'épaisseur de la matière formant la couche épaisse 20 au-dessus et au-dessous des éléments électroniques 8 et 10 est bien supérieure à celle de la couche interne 2 de la figure 1. L'ondulation de surface de la couche interne 2 de l'art antérieur n'est pas présente à nouveau après la formation de la couche épaisse 20 selon l'invention par une même technologie.

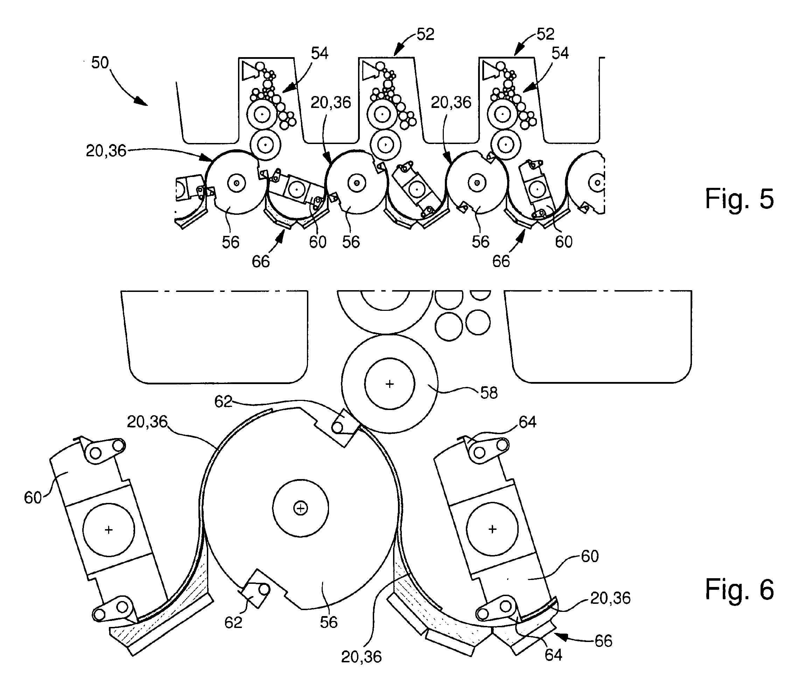

Selon le procédé de l'invention, il est prévu d'imprimer directement des premiers motifs 14 et, dans la variante décrite ici, des deuxièmes motifs 15 respectivement sur les deux faces 21 et 22 de la couche épaisse 20. Pour ce faire, il est prévu d'introduire la feuille épaisse 20 dans une installation d'impression. De préférence, l'installation d'impression est une installation agencée pour réaliser des impressions à haute définition permettant d'obtenir des motifs de très bonne qualité, en particulier avec des caractères ou signes difficilement perceptibles à l'oeil nu. Une installation d'impression préférée pour l'impression des premiers et deuxièmes motifs sur la couche épaisse 20 est représentée aux figures 5 et 6 et sera décrite par la suite.

Une fois les premiers et deuxièmes motifs 14 et 15 imprimés de chaque côtés de la feuille épaisse 20, il est prévu, dans une variante de mise en oeuvre particulière, de protéger ces motifs imprimés par deux films au moins partiellement transparents 16 et 17. Ces films 16 et 17 sont ainsi apportés de part et d'autre de la feuille épaisse 20 et assemblés à celle-ci par un laminage ou un collage sous presse (par exemple à surfaces de pression planes ou pressage en continu par des cylindres ou rubans). Cette étape d'assemblage ne nécessite pas ou que peu d'énergie thermique de sorte qu'il est possible d'assurer aisément la stabilité de la feuille épaisse 20, c'est-à-dire d'éviter toute déformation de ses surfaces 21 et 22. Ainsi, les motifs imprimés ne risquent pas dans le cadre de l'invention d'être détériorés par l'étape d'assemblage finale des couches. Finalement, les cartes sont découpées dans la plaque résultante selon les traits interrompus verticaux dans la figure 2.

Dans le cas de la formation d'une carte du type bancaire, c'est-à-dire ayant une épaisseur ISO comprise entre 0.76 et 0.84 mm, la couche épaisse 20 présente une épaisseur comprise entre 600 et 720 microns par exemple et chaque film externe transparent 16, 17 a une épaisseur comprise entre 60 et 80 microns. De manière générale, selon l'invention, la couche épaisse 20 présente de préférence une épaisseur sensiblement égale ou supérieure au deux tiers de l'épaisseur finale des cartes fabriquées. Dans l'exemple particulier donné ci-avant, l'épaisseur de la couche 20 est sensiblement égale ou supérieure à 600 microns (0.60 mm).

Dans le cas où la couche épaisse 20 est formée dans une presse de laminage avec un apport de chaleur pour former une couche compacte, la quantité d'énergie nécessaire à l'étape de formation de cette couche épaisse 20 est largement supérieure à la faible quantité d'énergie nécessaire au laminage des couches externes 16 et 17, lesquelles présentent une faible épaisseur relativement à l'épaisseur de la couche 20.

Dans une variante particulière, il est prévu d'apporter une fine couche de résine sur les faces 21 et 22 de la couche épaisse 20 ou sur les surfaces internes des couches transparentes 16 et 17. Une telle couche de résine sélectionnée de manière appropriée permet de définir une interface d'adhérence qui, notamment en présence des encres formant les motifs imprimés 14 et 15, permet d'augmenter l'adhérence des couches laminées et ainsi la solidité de l'assemblage de la couche 20 avec les films 16 et 17.

De manière générale, l'assemblage des films transparents à la couche épaisse ou l'apport d'un revêtement sur chaque motif imprimé sont réalisés de manière à assurer que ce film ou ce revêtement adhèrent correctement au corps de carte correspondant, c'est-à-dire à la feuille épaisse. Ainsi, le choix des encres et/ou des matériaux utilisés peut présenter une certaine importance. Comme mentionné ci-avant, la présence d'une interface d'adhérence, formée généralement par une fine couche de résine ou une laque quelconque, peut permettre d'assurer un assemblage solide et durable des films externes transparents avec la feuille épaisse centrale.

L'utilisation du terme couche épaisse ou feuille épaisse ne signifie pas que cette couche ou feuille épaisse ne peut être formée d'une pluralité de sous-couches constituées de mêmes matériaux ou de matériaux différents. Ainsi, la couche épaisse 20 peut être formée de divers matériaux et de plusieurs sous-couches selon un procédé connu de l'homme du métier. Ce qui importe, c'est que la couche ou feuille épaisse 20 constitue un support propre à recevoir l'impression d'une pluralité de motifs au moins à l'une de ses faces.

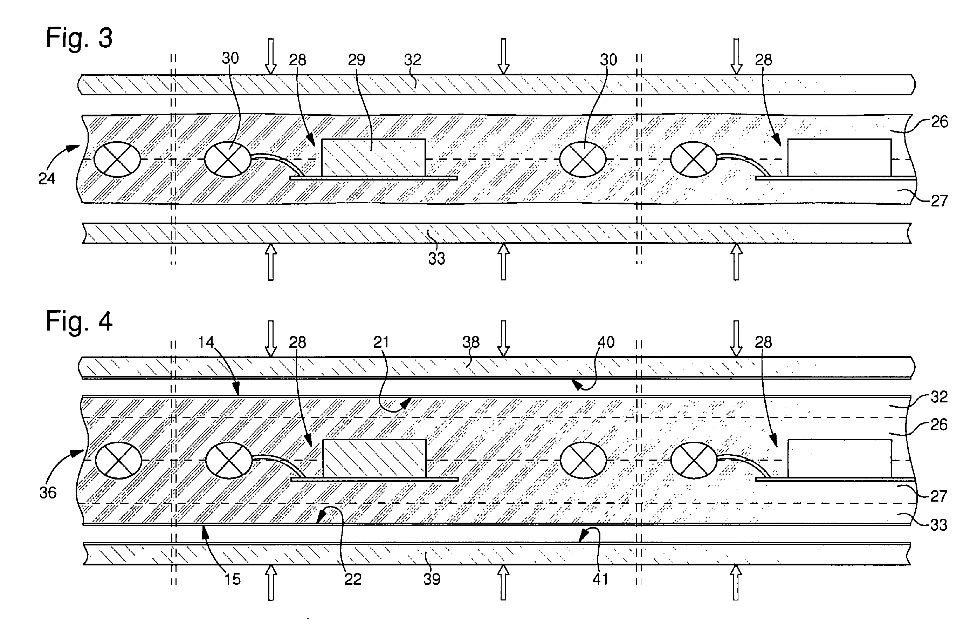

La figure 3 représente une variante perfectionnée de formation d'une feuille épaisse selon l'invention. Dans une première étape, une couche interne 24 est réalisée dans une installation de laminage avec deux couches plastiques 26 et 27 entre lesquelles sont agencées une pluralité d'unités électroniques 28, en particulier des unités de communication comprenant un circuit intégré 29 relié à une bobine ou antenne 30. Les couches 26 et 27 sont ramollies et pressées de manière à noyer au mieux les unités électroniques 28 dans la couche interne 24 ainsi formée. Etant donné que les couches 26 et 27 doivent être déformées de manière importante dans la région du circuit intégré 29 et de la bobine 30, avec un déplacement de matière résultant de la pénétration de ces éléments dans les deux couches, une certaine ondulation apparaît souvent aux surfaces de la couche interne 24 dans les zones où sont situés ces éléments électroniques.

On notera que dans d'autres variantes, d'autres unités ou modules électroniques peuvent être incorporées dans une couche interne 24, laquelle peut d'ailleurs être formée par diverses techniques connues de l'homme du métier. On notera également qu'au moins un élément électronique peut sensiblement être affleuré à au moins une surface de la couche interne 24.

Pour obtenir une feuille épaisse selon l'invention présentant des surfaces planes et uniformes, de manière à avoir un support d'impression de très bonne qualité, on agence deux couches 32 et 33, de préférence opaque et blanches, de part et d'autre de la couche interne 24 et on apporte le tout dans une installation de laminage pour former une structure multicouche 36. Dans cette deuxième étape de formation de la feuille épaisse 36, étant donné qu'aucun motif n'est alors imprimé en surface des couches 32 et 33, on peut apporter suffisamment d'énergie de manière à, d'une part, réduire des tensions internes résiduelles éventuelles dans la couche interne 24 et, d'autre part, à déformer légèrement les couches 32 et 33 pour compenser les ondulations présentes aux surfaces de la couche interne 24, le cas échéant.

Cette variante de formation de la feuille épaisse 36 présente divers avantages. En effet, la couche interne 24 peut être réalisée à bas coût sans qu'il soit nécessaire d'avoir à ce stade des surfaces correctement planes. Ensuite, cette couche 24 peut éventuellement présenter des surfaces non homogènes avec des matériaux différents, en particulier avoir au moins un élément électronique affleurant sensiblement sa surface. En particulier, la couche interne 24 peut être formée de matériaux transparents ou translucides qui ne sont pas appropriés pour une impression de qualité présentant un bon contraste. Dans une variante notamment, la couche interne 24 est formée par une résine apportée initialement dans un état liquide visqueux pour enrober l'unité électronique 28 et former ainsi une couche compacte présentant peu ou pas de tensions internes résiduelles.

L'apport des deux couches 32 et 33 et l'assemblage de ces deux couches à la couche interne 24 dans une installation de laminage permet d'obtenir une feuille épaisse 36 présentant des surfaces planes et lisses définissant ainsi de chaque côté de la feuille épaisse 36 une surface d'impression uniforme et au comportement homogène dans l'installation d'impression et finalement lors de l'étape ultérieure où deux films externes 38 et 39 sont apportés de part et d'autre de cette feuille épaisse et sont assemblés à celle-ci par laminage ou par collage, comme représenté schématiquement à la figure 4. A titre d'exemple, la couche interne 24 présente une épaisseur comprise entre 400 et 500 microns et les couches de recouvrement 32 et 33 ont une épaisseur comprise entre 80 et 100 microns. De préférence, les épaisseurs sont sélectionnées de manière à obtenir une feuille épaisse 36 présentant une épaisseur comprise entre 600 et 720 microns.

Dans le procédé perfectionné décrit en référence à la figure 4, comme dans le procédé de base selon l'invention, une pluralité de premiers motifs 14 est imprimé sur la face 21 de la feuille épaisse 36 dans une installation permettant d'obtenir une impression à haute définition. Ensuite, une deuxième pluralité de motifs 40 est imprimée sur un film au moins partiellement transparent 38 ayant par exemple une épaisseur comprise entre 80 et 100 microns. Dans la variante représentée à la figure 4, des troisièmes motifs 15 sont également imprimés sur la face 22 de la feuille épaisse 36 et de quatrièmes motifs 41 sont imprimés sur un deuxième film externe au moins partiellement transparent 39. Dans une variante particulière, seuls les troisièmes motifs 15 sont prévus du côté de la face 22 de la feuille épaisse 36 alors que dans une autre variante, seuls les quatrièmes motifs 41 imprimés sur le film 39 sont prévus du côté de cette face 22. De préférence, le film 39 présente une épaisseur sensiblement identique à celle du film 38.

Après que l'ensemble des motifs imprimés mentionnés ci-avant sont réalisés, les films 38 et 39 sont assemblés à la feuille épaisse 36 avec la pluralité de motifs 40 et, le cas échéant, la pluralité de motifs 41 agencées sur la surface interne du film correspondant, c'est-à-dire les faces imprimées du film 38 et, respectivement, du film 39 sont situées du côté de la feuille épaisse 36, de manière que les films externes 38 et 39 forment des revêtements de protection des motifs imprimés. Cet assemblage final est effectué par laminage ou par collage avec un faible apport d'énergie, voire sans apport de chaleur. Les premiers et deuxièmes motifs imprimés sont ainsi situés sensiblement à un même niveau, ce qui donne un meilleur aspect visuel et un meilleur contraste de lecture pour les deuxièmes motifs.

Dans un mode de mise en oeuvre préféré, il est prévu, après l'impression des premiers motifs 14 et, le cas échéant, des troisièmes motifs 15 sur les faces de la feuille épaisse 36, de recouvrir la ou les face(s) imprimée(s) d'un film de protection, d'une couche de résine ou d'une laque pour protéger ces motifs imprimés au moins temporairement. Ceci est réalisé dès que possible après avoir réalisé l'impression des motifs prévus sur la feuille 36.

Dans une première variante, le film de protection ou la laque sont agencés de manière amovible et sont retirés avant l'étape d'assemblage final représentée à la figure 4. Ils ont donc une fonction de protection temporaire entre le moment où la feuille 36 est imprimée dans une installation appropriée et l'étape d'assemblage avec les films externes 38 et 39 dont au moins le premier présente également une pluralité de motifs imprimés.

Dans une seconde variante, le film de protection ou la laque apportés à la surface de la feuille épaisse 36 demeurent solidement assemblés à celle-ci et constituent alors des couches des cartes finies. Dans ce cas, on sélectionnera le matériau formant ce film de protection ou cette laque pour former une interface d'adhérence entre la feuille épaisse 36 et les films 38 et 39. Comme dans le procédé de base décrit précédemment, on peut dans chacune de ces variantes prévoir en plus le dépôt d'une fine couche de résine entre la feuille épaisse 36 et les films externes 38 et 39 pour augmenter l'adhérence de ces films externes. Une interface d'adhérence entre les premiers et deuxièmes motifs superposés l'un à l'autre dans les cartes finies peut dans certains cas augmenter considérablement l'adhérence des films externes à la couche épaisse centrale, étant donné la présence des encres formant ces motifs imprimés qui, dans certains cas, présentent une faible adhérence soit à cette feuille épaisse, soit au film externe.

On remarquera ici que les films externes 38 et 39 sont apportés sur la feuille épaisse 36 ou qu'une pluralité de films distincts, présentant chacun un motif imprimé sur une face, sont apportés respectivement sur une pluralité de corps de carte formés par la feuille épaisse. Dans les deux cas, cette opération est effectuée de préférence avant le découpage final des cartes dans la plaque obtenue. Cependant, dans une variante, il est possible que les corps de cartes soient découpés dans la feuille épaisse et qu'ensuite la pluralité de films externes, comportant chacun un motif imprimé sur une de leur face, soit respectivement apportés sur les corps de carte obtenus et assemblés à ceux-ci dans un procédé carte à carte. Dans ce dernier cas, on peut encore prévoir d'effectuer à nouveau un découpage d'un contour final de la carte pour obtenir un bord net. De préférence, ce contour final est effectué à l'intérieur du contour initial du corps de carte découpé.

La feuille épaisse 36 forme donc un produit intermédiaire évolué ou un produit semi-fini dans la fabrication de cartes selon l'invention. La fabrication de la feuille épaisse 36 demande un savoir-faire propre à certains producteurs de cartes. Comme mentionné précédemment, la formation d'une couche épaisse, présentant une épaisseur égale ou supérieure aux deux tiers de l'épaisseur finale des cartes, permet d'obtenir par un procédé approprié des surfaces parfaitement planes et de préférence lisses, qui forment un excellent support d'impression. Ainsi, en particulier, il est prévu d'imprimer au moins un premier motif sur une première face de la feuille épaisse 36 dans une installation d'impression permettant d'effectuer des impressions à haute définition. Pour ce faire, il est prévu selon l'invention d'introduire la feuille épaisse 36 directement dans l'installation d'impression. Selon une variante préférée de l'invention, la feuille épaisse 36 est introduite dans une installation d'impression du type Offset ou similaire dans laquelle l'impression est effectuée sur des cylindres.

Ensuite, dans le procédé perfectionné selon l'invention, il est prévu d'apporter un film au moins partiellement transparent 38, présentant sur sa surface interne des deuxièmes motifs imprimés, sur la première face de la feuille épaisse 36 où sont imprimés les premiers motifs. L'assemblage de cette feuille épaisse avec le film 38 est effectué de préférence avant le découpage des cartes dans la plaque résultante. Dans une variante plus élaborée, telle que représentée à la figure 4, il est également prévu des troisièmes motifs imprimés sur la seconde face de la feuille épaisse 36 et des quatrièmes motifs imprimés sur la surface interne d'un deuxième film de recouvrement des troisièmes motifs. On peut toutefois avoir diverses variantes et par exemple prévoir des cartes ayant un côté verso présentant un seul motif imprimé. En particulier, si le motif prévu du côté verso de la carte a un caractère général et commun au lot de cartes fabriquées en plaque, l'impression sera réalisée de préférence sur la deuxième face 15 de la feuille épaisse 36.

L'impression sur la seconde face 22 peut, dans une variante particulière, définir seulement un fond uniforme d'une certaine couleur. Dans le cas où seuls des troisièmes motifs sont prévus du côté verso de la carte et que ceux-ci sont imprimés sur la seconde face de la feuille épaisse, il n'est pas nécessaire alors de prévoir l'apport d'un film externe, mais on peut alors prévoir seulement l'apport d'une laque ou d'une encre transparente déposées notamment à l'aide d'un film de transfert. Cette laque ou cette encre transparente définit un revêtement de protection des troisièmes motifs imprimés. On notera que le passage terminal dans une presse de laminage pour assembler, notamment par collage, la feuille épaisse avec le film transparent apporté sur la première face de cette feuille épaisse peut également servir à améliorer l'état de surface de la laque ou de l'encre transparente de protection apportés précédemment au verso de la feuille épaisse. Cette étape d'assemblage finale peut donc permettre d'obtenir une surface lisse et brillante au verso de la carte sans apport de film externe. Toutefois, on remarquera qu'il est préférable de prévoir une structure multicouche symétrique si un apport de chaleur est prévu pour l'assemblage final.

La plaque obtenue pour le procédé de fabrication perfectionné constitue un objet de l'invention, tout comme les cartes découpées ensuite dans une telle plaque.

La fabrication d'un produit intermédiaire ou produit semi-fini sous forme d'une feuille épaisse 36 incorporant les unités électroniques prévues et présentant à au moins une de ses faces une pluralité de premiers motifs, protégée ou non par un film ou une laque, présente un avantage important notamment pour la fabrication de cartes d'identité, de permis de conduire ou tous autres documents officiels comprenant en particulier des données personnelles. Les données personnelles sont généralement protégées par l'Etat qui délivre les cartes d'identité, les permis de conduire ou ces autres documents à caractère officiel. Pour des raisons de confidentialité et de protection des données personnelles, il est possible que certains Etats ne souhaitent pas les transmettre à un producteur de cartes situé à l'étranger. Toutefois, comme la fabrication de cartes incorporant des unités électroniques et ayant, pour des raisons sécuritaires, des motifs imprimés à haute définition et difficilement reproductibles ne peut pas toujours être effectuée dans le pays concerné, la présente invention apporte une solution efficace à ce problème.

En effet, il est possible selon l'invention de réaliser les cartes en deux étapes distinctes. D'une part, on fabrique la feuille épaisse comprenant les unités électroniques et présentant des surfaces planes de très bonne qualité et on imprime selon l'invention au moins une pluralité de motifs du type sécuritaire à une face de cette feuille épaisse. L'impression de tels motifs sécuritaires nécessite des moyens relativement complexes et onéreux et un savoir-faire particulier. Ainsi les opérations nécessitant un savoir-faire spécifique et des moyens de production complexes et onéreux peuvent être réalisées de manière délocalisés chez un des quelques producteurs à même de réaliser un tel produit intermédiaire. D'autre part, l'impression des données variables et/ou personnelles peut être réalisée par le client, notamment un Etat donné, à l'intérieur des frontières de cet Etat. Les motifs personnalisés ne nécessitent généralement pas une haute définition et peuvent donc être réalisés dans des installations d'impression conventionnelles, moins complexes et moins onéreuses, sur un film plastique transparent qui est laminé ensuite avec la feuille épaisse selon l'invention. Dans cette seconde phase, le client peut continuer la fabriction des cartes en plaque ou prévoir de finir les cartes dans une installation carte à carte. Dans un tel cas, il peut recevoir des corps de carte imprimés et déjà découpés dans le produit intermédiaire selon l'invention.

Comme déjà mentionné, l'apport et l'assemblage du film transparent à la feuille épaisse est réalisé de préférence avant le découpage du lot de cartes. Toutefois, il est possible d'envisager de le réaliser carte à carte après avoir découpé la pluralité de corps de carte dans la feuille épaisse. Cette dernière variante est moins avantageuse et pose un problème de qualité de la carte finie, notamment au niveau du bord de la carte. C'est pourquoi, dans le cadre de la présente invention, la solution préférée consiste à assembler la feuille épaisse imprimée avec le film au moins partiellement transparent et imprimé avant de découper les cartes dans la plaque résultante.

La programmation éventuelle des unités électroniques peut être effectuée de diverses manières et à divers moments. Certaines données peuvent être introduites lors de la fabrication des unités électroniques ; d'autres données peuvent être programmées après la fabrication de la feuille épaisse et d'autres données peuvent encore être introduites par le client, notamment par l'Etat concerné dans le cas de cartes d'identité, de permis de conduire ou même de cartes bancaires, après qu'il ai reçu les feuilles épaisses imprimées. Le motif imprimé sur le film transparent peut notamment dépendre du contenu d'une mémoire agencée dans l'unité électronique, laquelle est lue pour générer le motif imprimé. Chaque module électronique peut ainsi avoir un numéro unique ou un code personnel et chaque motif personnalisé imprimé sur le film transparent présente au moins une donnée variable relative à ce numéro unique ou code personnel de l'unité électronique correspondante. Le film transparent est ensuite apporté sur la feuille épaisse de manière à ce que les premiers motifs personnalisés soient placés en regard des unités électroniques correspondantes. La gestion de ces étapes et l'introduction des diverses données peuvent être réalisées à l'aide de moyens informatiques connus de l'homme du métier.

Le laminage des films au moins partiellement transparents 38 et 39 avec la feuille épaisse 36 peut être réalisé avec un faible apport d'énergie relativement à la quantité d'énergie utilisée pour former la feuille épaisse 36.

L'assemblage final peut être réalisé sous une presse relativement simple sans nécessiter un grand savoir-faire. Les films externes 38 et 39 sont relativement peu épais par rapport à la feuille épaisse 36, laquelle reste stable et ne se déforme pas au cours de cette étape. Les films externes 38 et 39 sont généralement stabilisés par les surfaces de la presse. Comme déjà mentionné, il est possible de prévoir une interface d'adhérence, sous forme d'une fine couche de résine, d'une laque ou même une encre transparente, sélectionnée pour ses caractéristiques d'adhérence aux matériaux de la feuille épaisse et des films externes. Le client peut donc réaliser aisément des cartes terminées de très bonne qualité et présentant des motifs imprimés à haute définition; ce qui permet ainsi de délivrer un titre officiel fiable et difficilement reproductible.

A l'aide des figures 5 à 6 on décrira ci-après une installation d'impression à haute définition du type Offset prévue dans une variante préférée pour l'impression de motifs sur au moins une des faces des feuilles épaisses 20, 36. Il ne s'agit pas ici de donner une explication détaillée de l'installation d'impression qui est connue de l'homme du métier dans ce domaine. Il s'agit plutôt de montrer le parcours des feuilles épaisses 20, 36 dans cette installation d'impression. L'installation comprend une pluralité d'unités d'impression 52 agencées pour imprimer sur les feuilles 20, 36 une couleur de base différente dans chacune de ces unités 52. Pour ce faire, chaque unité comprend une pluralité de rouleaux encreur 54 représentés schématiquement. Un cylindre 56 servant de support à la feuille imprimée est associé à chaque unité d'impression 52. La feuille 20, 36 est étendue successivement sur chacun de ces cylindres 56 qui entraînent la feuille de manière synchrone avec un rouleau encreur terminal 58. Entre deux cylindres adjacents 56 est prévu un dispositif rotatif 60 pour le transfert des feuilles entre les diverses unités d'impression. Des moyens de préhension 62 et 64 sont respectivement agencés sur les cylindres 56 et sur les dispositifs rotatif 60. Ces moyens de préhension servent à tirer les feuilles épaisses 20, 36 et à les entraîner en rotation avec le cylindre 56, respectivement le dispositif rotatif de transfert 60. On remarque que les feuilles épaisses 20, 36 sont ainsi incurvées à plusieurs reprises dans cette installation d'impression Offset. Sur les cylindres d'impression 56, les feuilles sont incurvées de manière convexe alors qu'elles sont incurvées concaves dans les zones de transfert 66. On constate donc que les feuilles épaisses 20, 36 subissent des contraintes mécaniques dans l'installation d'impression où elles sont momentanément cintrées. De telles installations sont prévues pour l'impression de simples feuilles souples et homogènes. L'utilisation de telles installations d'impression dans le cadre de la présente invention va à l'encontre des préjugés de l'homme du métier et permet de réaliser directement sur une feuille épaisse, incorporant les diverses unités électroniques prévues, des impressions à haute définition propres notamment à la réalisation de motifs sécuritaires.

## Revendications

1. Procédé de fabrication de cartes comprenant chacune au moins une unité électronique incorporée dans un corps de carte et au moins un premier motif imprimé du côté d'une première face de ce corps de carte, **caractérisé en ce qu'**il comporte les étapes suivantes :
A) Formation d'une pluralité de corps de carte sous forme d'une feuille épaisse dans laquelle est incorporée respectivement une pluralité d'unités électroniques ;
B) Impression d'une pluralité de premiers motifs sur une première face de ladite feuille épaisse dans une installation d'impression dans laquelle une encre est déposée sur ladite première face pour réaliser cette pluralité de premiers motifs respectivement sur ladite pluralité de corps de carte;
C) Apport d'un revêtement au moins partiellement transparent sur chaque premier motif imprimé de manière qu'il adhère audit corps de carte respectif.

2. Procédé selon la revendication 1, **caractérisé en ce qu'**il est en outre prévu d'effectuer l'impression d'une pluralité de deuxièmes motifs sur la seconde face de ladite feuille épaisse dans une installations d'impression dans laquelle une encre est déposée sur cette seconde face pour réaliser la pluralité de deuxièmes motifs respectivement sur ladite pluralité de corps de carte, et **en ce qu'**il est prévu d'apporter également un revêtement au moins partiellement transparent sur chaque deuxième motif de manière qu'il adhère audit corps de carte respectif.

3. Procédé selon la revendication 2, **caractérisé en ce que** ladite feuille épaisse, qui forme la pluralité de corps de carte où sont incorporés les unités électroniques respectives, présente une épaisseur sensiblement égale ou supérieure aux deux tiers de l'épaisseur finale des cartes fabriquées, les deux revêtements étant formés respectivement par deux films externes.

4. Procédé selon la revendication 3, dans lequel lesdites cartes ont une épaisseur ISO comprise entre 0.76 et 0.84 mm, **caractérisé en ce que** l'épaisseur de ladite feuille épaisse imprimée est sensiblement égale ou supérieure à 0.60 mm.

5. Procédé selon l'une des revendications 2 à 4, **caractérisé en ce que** lesdits revêtements sont laminés avec ladite feuille épaisse avec un faible apport d'énergie thermique ou sans apport d'énergie thermique.

6. Procédé selon l'une des revendications précédentes, **caractérisé en ce que** ladite installation d'impression est formée de plusieurs cylindres servant de support d'impression, ladite feuille épaisse incorporant ladite pluralité d'unités électroniques étant agencée successivement à la surface de ces cylindres lors de l'étape d'impression et étant ainsi incurvée à plusieurs reprises dans cette installation d'impression.

7. Procédé selon la revendication 6, **caractérisé en ce que** ladite installation d'impression est une installation d'impression offset ou similaire permettant de réaliser des impressions à haute définition.

8. Procédé selon la revendication 6 ou 7, **caractérisé en ce que** ledit premier motif définit une impression sécuritaire, laquelle peut notamment contenir des motifs d'impression quasi imperceptibles à l'oeil nu.

9. Procédé de fabrication de cartes selon l'une quelconque des revendications 1 à 8, dans lequel ledit revêtement au moins partiellement transparent est formé par un film recouvrant ladite pluralité de premiers motifs ou par une pluralité de films distincts au moins partiellement transparents recouvrant respectivement ladite pluralité de corps de carte, **caractérisé en ce qu'**il comporte en outre, avant ladite étape C), l'étape suivante :
D) Impression d'une pluralité de troisièmes motifs sur une face dudit film ou sur des faces respectives de ladite pluralité de films ;
et **en ce que** ladite étape C) est mise en oeuvre par les deux sous-étapes suivantes :
C1) Agencement dudit film ou de ladite pluralité de films du côté de ladite première face de ladite feuille épaisse, chaque troisième motif étant situé au-dessus d'un corps de carte différent , ou, dans le cas où une étape de découpage des corps de carte dans ladite feuille épaisse intervient suite à ladite étape B), de ladite pluralité de films sur ladite pluralité respective de corps de carte découpés, de manière que la face imprimée de ce film ou de ces films soit située du côté de ladite pluralité de corps de carte et que lesdits premiers motifs soient au moins partiellement visibles au travers dudit film ou desdits films ; et
C2) Assemblage de ladite feuille épaisse avec ledit film ou ladite pluralité de films ou de chaque corps de carte découpé avec un desdits films.

10. Procédé selon la revendication 9, **caractérisé en ce qu'**il est prévu, après l'étape d'impression B) et avant l'étape C), de recouvrir ladite première face imprimée d'un film de protection ou d'une laque de manière à protéger lesdits premiers motifs imprimés.

11. Procédé selon la revendication 10, **caractérisé en ce que** ledit film de protection ou ladite laque sont agencés de manière amovible à ladite première face imprimée de ladite feuille épaisse et sont enlevés avant l'étape C).

12. Procédé selon la revendication 9 ou 11, **caractérisé en ce qu'**une fine couche de résine est déposée soit sur ladite première face imprimée de ladite feuille épaisse, soit sur la face imprimée dudit film ou desdits films, cette fine couche de résine étant sélectionnée de manière à former une interface d'adhérence entre ce film ou ces films et la feuille épaisse.

13. Procédé selon la revendication 10, **caractérisé en ce que** ledit film de protection ou ladite laque forment une couche des cartes et sont sélectionnés de manière à former une interface d'adhérence entre ledit film ou lesdits films et ladite feuille épaisse ou lesdits corps de carte découpés.

14. Procédé selon l'une des revendications 9 à 13, **caractérisé en ce que** les étapes B) et C) sont réalisées dans des sites de production différents.

15. Procédé selon l'une des revendications 9 à 14, **caractérisé en ce que** ledit premier motif définit une impression sécuritaire de base et **en ce que** ledit deuxième motif définit une impression personnalisée.

16. Procédé selon la revendication 15, **caractérisé en ce que** ladite impression personnalisée nécessite une impression présentant une moindre définition que ladite impression sécuritaire.

17. Procédé selon la revendication 15 ou 16, **caractérisé en ce que** ladite impression sécuritaire de base est une impression à haute définition, laquelle peut notamment contenir des éléments d'impression quasi imperceptibles à l'oeil nu.

18. Procédé selon l'une des revendications 9 à 14, **caractérisé en ce que** ledit film ou lesdits films est (sont) laminé(s) avec ladite feuille épaisse ou lesdits corps de carte découpés par un faible apport d'énergie thermique ou sans apport de chaleur.

19. Procédé selon l'une des revendications 9 à 18, **caractérisé en ce que** ladite installation d'impression est formée de plusieurs cylindres servant de support d'impression, ladite feuille épaisse incorporant ladite pluralité d'unités électroniques étant agencée successivement à la surface de ces cylindres lors de l'étape d'impression et étant ainsi incurvée à plusieurs reprises dans cette installation d'impression.

20. Procédé selon la revendication 19, **caractérisé en ce que** ladite installation d'impression est une installation d'impression Offset ou similaire permettant de réaliser des impressions à haute définition.

21. Procédé selon l'une des revendications 9 à 20, **caractérisé en ce qu'**il est également prévu d'effectuer l'impression d'une pluralité de quatrièmes motifs sur un deuxième film au moins partiellement transparent et d'apporter ce deuxième film à la seconde face de ladite feuille épaisse de manière à ce que ladite face imprimée de ce film soit située du côté de cette feuille épaisse, chaque quatrième motif étant situé au-dessus d'un corps de carte différent.

22. Produit intermédiaire intervenant dans la fabrication de cartes électroniques, **caractérisé en ce qu'**il est formé par une feuille incorporant une pluralité d'unités électroniques et définissant une pluralité respective de corps de carte, cette feuille présentant du côté d'une première face une pluralité de premiers motifs imprimés avec une encre qui sont chacun associés à un corps de carte différent.

23. Produit intermédiaire selon la revendication 22, **caractérisé en ce que** ladite pluralité de premiers motifs est recouverte par un revêtement de protection, en particulier par un film plastique, une couche de résine ou une laque.

24. Produit intermédiaire selon la revendication 23, **caractérisé en ce que** ledit revêtement de protection est agencé de manière amovible sur ladite première face de ladite feuille.

25. Produit intermédiaire selon la revendication 23, **caractérisé en ce que** ledit revêtement de protection adhère solidement à ladite feuille et est destiné à former une couche des cartes fabriquées à partir de ce produit intermédiaire.

26. Produit intermédiaire selon l'une quelconque des revendications 22 à 25, caractérisé en ce lesdits premiers motifs définissent des motifs sécuritaires.

27. Produit intermédiaire selon l'une quelconque des revendications 22 à 25, **caractérisé en ce que** ladite feuille présente du côté de sa seconde face une pluralité de deuxièmes motifs imprimés qui sont chacun associé à un corps de carte différent.

28. Plaque formant une pluralité de cartes et comprenant une feuille ou couche épaisse incorporant une pluralité d'unités électroniques, cette feuille ou couche épaisse définissant une pluralité respective de corps de carte et présentant sur une première face une pluralité de premiers motifs imprimés avec une encre, cette plaque comprenant en outre un film au moins partiellement transparent agencé à ladite première face de ladite feuille ou couche épaisse et présentant une pluralité de deuxièmes motifs imprimés sur sa surface interne, chaque corps de carte étant associé à un premier motif et un deuxième motif qui sont situés sensiblement à un même niveau de la carte.

29. Plaque selon la revendication 28, **caractérisée en ce que** ladite pluralité de premiers motifs et ladite pluralité de deuxièmes motifs sont séparés l'une de l'autre par une fine couche au moins partiellement transparente formant une interface d'adhérence.

30. Plaque selon la revendication 28 ou 29, **caractérisée en ce que** les premiers motifs définissent des motifs sécuritaires à haute définition et les deuxièmes motifs définissent au moins en partie des données personnelles.

31. Plaque selon l'une des revendications 28 à 30, **caractérisée en ce que** les premiers motifs sont imprimés dans une installation d'impression du type Offset ou similaire.

32. Plaque selon l'une des revendications 28 à 31, **caractérisée en ce qu'**elle présente du côté de sa seconde face au moins une pluralité de troisième motifs imprimés et protégés par un revêtement au moins partiellement transparent.

## Claims

1. Method of fabricating cards that each include at least one electronic unit incorporated in a card body and at least a first printed pattern on the side of a first surface of said card body, **characterized in that** it includes the following steps:
A) Forming a plurality of card bodies in the form of a thick sheet that incorporates respectively a plurality of electronic units;
B) Printing a plurality of first patterns on a first surface of said thick sheet in a printing station in which an ink is deposited on said first surface to form this plurality of first patterns respectively on said plurality of card bodies;
C) Placing an at least partially transparent coating on each first printed pattern so that it adheres to the respective card body.

2. Method according to claim 1, **characterized in that** it also includes printing a plurality of second patterns on the second surface of said thick sheet in a printing station in which an ink is deposited on this second surface so that the plurality of second patterns respectively lie on said plurality of card bodies, and adding an at least partially transparent coating on each second printed pattern so that it adheres to the respective card body.

3. Method according to claim 2, **characterized in that** said thick sheet, which forms the plurality of card bodies where the respective electronic units are incorporated, has a thickness that is approximately equal to or greater than two thirds of the final thickness of the fabricated cards, the two coatings being respectively formed by two outlays.

4. Method according to claim 3, wherein said cards have an ISO thickness of between 0.76 and 0.84 mm, **characterized in that** the thickness of said thick printed sheet is approximately equal to or greater than 0.60 mm.

5. Method according to any of claims 2 to 4, **characterized in that** said coatings are laminated with said thick sheet with a small supply of thermal energy or without any supply of thermal energy.

6. Method according to any of the preceding claims, **characterized in that** said printing station is formed of several cylinders used as a printing support, said thick sheet incorporating said plurality of electronic units being arranged in succession at the surface of said cylinders during the printing step and thus being bent several times in said printing station.

7. Method according to claim 6, **characterized in that** said printing station is an Offset printing station or similar for high definition printing.

8. Method according to claim 6 or 7, **characterized in that** said first pattern defines a security print, which may in particular contain printing patterns that are virtually imperceptible to the naked eye.

9. Method of fabricating cards according to any of claims 1 to 8, in which said at least partially transparent coating is formed by a film covering said plurality of first patterns or by a plurality of separate at least partially transparent films which respectively cover said plurality of card bodies, **characterized in that** it also includes, before said step C), the following step:
D) Printing a plurality of third patterns on a surface of said film or on respective surfaces of said plurality of films;
and **in that** said step C) is implemented by the two following substeps:
C1) Arranging said film or said plurality of films on the side of said first surface of said thick sheet, each third pattern being located above a different card body, or, when a step of cutting the card bodies in said thick sheet follows said step B), said plurality of films on said respective plurality of cut card bodies, such that the printed surface of the film or films is located on the side of said plurality of card bodies and that said first patterns are at least partially visible through said film or said films; and
C2) Assembling said thick sheet with said film or said plurality of films or each cut card body with one of said films.

10. Method according to claim 9, **characterized in that**, after printing step B) and before step C), said method includes a step of covering said first printed surface with a protective film or a lacquer so as to protect said first printed patterns.

11. Method according to claim 10, **characterized in that** said protective film or said lacquer are arranged in a removable manner on said first printed surface of said thick sheet and are removed prior to step C).

12. Method according to claim 9 or 11, **characterized in that** a thin resin layer is deposited either on said first printed surface of said thick sheet or on the printed surface of said film or said films, said thin resin layer being selected to form an adherence interface between said film or said films and the thick sheet.

13. Method according to claim 10, **characterized in that** said protective film or said lacquer form a layer of the cards and are selected so as to form an adherence interface between said film or said films and said thick sheet or said cut card bodies.

14. Method according to any of claims 9 to 13, **characterized in that** steps B) and C) are performed in different production sites.

15. Method according to any of claims 9 to 14, **characterized in that** said first pattern defines a basic security print and **in that** said second pattern defines a personalised print.

16. Method according to claim 15, **characterized in that** said personalised print requires a print with less definition than said security print.

17. Method according to claim 15 or 16, **characterized in that** said basic security print is a high definition print, which may contain print elements that are virtually imperceptible to the naked eye.

18. Method according to any of claims 9 to 14, **characterized in that** said film or said films is/are laminated with said thick sheet or said cut card bodies by a small supply of thermal energy or without any supply of thermal energy.

19. Method according to any of claims 9 to 18, **characterized in that** said printing station is formed of several cylinders used as printing supports, said thick sheet incorporating said plurality of electronic units being arranged in succession on the surface of said cylinders during the printing step and being thus bent several times in said printing station.

20. Method according to claim 19, **characterized in that** said printing station is an Offset printing station or similar for high definition printing.

21. Method according to any of claims 9 to 20, **characterized in that** it also comprises a step of printing a plurality of fourth patterns on an at least partially transparent second film and adding said second film to the second surface of said thick sheet so that said printed face of this second film is located on the side of said thick sheet, each fourth pattern being located above a different card body.

22. Intermediate product involved in the fabrication of electronic cards, **characterized in that** it is formed by a sheet incorporating a plurality of electronic units and defining a respective plurality of card bodies, said sheet having, on the side of a first surface, a plurality of first patterns printed with an ink, which are each associated with a different card body.

23. Intermediate product according to claim 22, **characterized in that** said plurality of first patterns is covered with a protective coating, in particular by a plastic film, a resin layer or a lacquer.

24. Intermediate produce according to claim 23, **characterized in that** said protective coating is arranged in a removable manner on said first surface of said sheet.

25. Intermediate product according to claim 23, **characterized in that** said protective coating adheres securely to said sheet and is for forming a layer of cards fabricated from said intermediate product.

26. Intermediate product according to any of claims 22 to 25, **characterized in that** said first patterns define security patterns.

27. Intermediate product according to any of claims 22 to 25, **characterized in that** said sheet has on the side of its second surface a plurality of second printed patterns which are each associated with a different card body.

28. Plate forming a plurality of cards and including a thick sheet or layer incorporating a plurality of electronic units, said thick sheet or layer defining a respective plurality of card bodies and having, on a first surface, a plurality of first patterns printed with an ink, said plate further including an at least partially transparent film arranged on said first surface of said thick sheet or layer and having a plurality of second patterns printed on the inner surface thereof, each card body being associated with a first pattern and a second pattern, which are approximately located at the same level of the card.

29. Plate according to claim 28 **characterized in that** said plurality of first patterns and said plurality of second patterns are separated from each other by a thin, at least partially transparent layer forming an adherence interface.

30. Plate according to claim 28 or 29, **characterized in that** the first patterns define high definition security patterns and the second patterns define at least in part personal data.

31. Plate according to any of claims 28 to 30, **characterized in that** the first patterns are printed in an Offset type printing station or similar.

32. Plate according to any of claims 28 to 31, **characterized in that** it has, on the side of the second surface thereof, at least one plurality of third printed patterns protected by an at least partially transparent coating.

## Patentansprüche

1. Verfahren zur Herstellung von Karten, die jeweils wenigstens eine elektronische Einheit, die in einen Kartenkörper eingearbeitet ist, und wenigstens ein erstes gedrucktes Muster auf Seiten einer ersten Fläche dieses Kartenkörpers umfasst, **dadurch gekennzeichnet, dass** es die folgenden Schritte umfasst:
A) Bilden mehrerer Kartenkörper in Form einer dicken Folie, in die mehrere elektronische Einheiten entsprechend eingearbeitet sind;
B) Drucken mehrerer erster Muster auf eine erste Fläche der dicken Folie in einer Druckanlage, in der eine Tinte auf die erste Fläche aufgebracht wird, um diese mehreren ersten Muster auf den mehreren jeweiligen Kartenkörpern zu verwirklichen;
C) Anbringen einer wenigstens teilweise transparenten Beschichtung auf jedem ersten gedruckten Muster in der Weise, dass sie an dem jeweiligen Kartenkörper haftet.

2. Verfahren nach Anspruch 1, **dadurch gekennzeichnet, dass** außerdem vorgesehen ist, ein Drucken mehrerer zweiter Muster auf die zweite Fläche der dicken Folie in einer Druckanlage, in der eine Tinte auf diese zweite Fläche aufgebracht wird, vorzunehmen, um die mehreren zweiten Muster auf den mehreren jeweiligen Kartenkörpern zu verwirklichen, und dass vorgesehen ist, außerdem eine wenigstens teilweise transparente Beschichtung auf jedem zweiten Muster in der Weise anzubringen, dass sie an dem jeweiligen Kartenkörper haftet.

3. Verfahren nach Anspruch 2, **dadurch gekennzeichnet, dass** die dicke Folie, die die mehreren Kartenkörper bildet, dort, wo die jeweiligen elektronischen Einheiten eingearbeitet sind, eine Dicke aufweist, die im Wesentlichen gleich oder größer als zwei Drittel der endgültigen Dicke der gefertigten Karten ist, wobei die zwei Beschichtungen durch zwei jeweilige externe Filme gebildet werden.

4. Verfahren nach Anspruch 3, wobei die Karten eine ISO-Dicke im Bereich von 0,76 bis 0,84 mm haben, **dadurch gekennzeichnet, dass** die Dicke der gedruckten dicken Folie im Wesentlichen gleich oder größer als 0,60 mm ist.

5. Verfahren nach einem der Ansprüche 2 bis 4, **dadurch gekennzeichnet, dass** die Beschichtungen mit der dicken Folie unter geringer Einbringung von Wärmeenergie oder ohne Einbringung von Wärmeenergie laminiert werden.

6. Verfahren nach einem der vorhergehenden Ansprüche, **dadurch gekennzeichnet, dass** die Druckanlage aus mehreren Zylindern gebildet ist, die als Druckträger dienen, wobei die dicke Folie, in die die mehreren elektronischen Einheiten eingearbeitet sind, im Druckschritt nacheinander auf der Oberfläche dieser Zylinder angeordnet wird und somit in dieser Druckanlage mehrmals gekrümmt wird.

7. Verfahren nach Anspruch 6, **dadurch gekennzeichnet, dass** die Druckanlage eine Offsetdruckanlage oder dergleichen ist, die die Ausführung hoch auflösender Drucke ermöglicht.

8. Verfahren nach Anspruch 6 oder 7, **dadurch gekennzeichnet, dass** das erste Muster einen Sicherheitsdruck definiert, der insbesondere Druckmuster enthalten kann, die für das bloße Auge nahezu nicht wahrnehmbar sind.

9. Verfahren für die Fertigung von Karten nach einem der Ansprüche 1 bis 8, wobei die wenigstens teilweise transparente Beschichtung durch einen Film, der die mehreren ersten Muster abdeckt, oder durch mehrere verschiedene wenigstens teilweise transparente Filme, die jeweils die mehreren Kartenkörper abdecken, gebildet ist, **dadurch gekennzeichnet, dass** es außerdem vor dem Schritt C) den folgenden Schritt umfasst:
D) Drucken mehrerer dritter Muster auf eine Fläche des Films oder auf die jeweiligen Flächen der mehreren Filme;
und dass der Schritt C) durch die zwei folgenden Unterschritte ausgeführt wird:
C1) Anordnen des Films oder der mehreren Filme auf Seiten der ersten Fläche der dicken Folie, wobei sich jedes dritte Muster über einem anderen Kartenkörper befindet, oder in dem Fall, in dem nach dem Schritt B) ein Schritt des Ausstanzens des Kartenkörpers in der dicken Folie erfolgt, Anordnen der mehreren Filme auf den mehreren jeweiligen ausgestanzten Kartenkörpern, derart, dass sich die bedruckte Fläche dieses Films oder dieser Filme auf Seiten der mehreren Kartenkörper befinden und die ersten Muster wenigstens teilweise durch diesen Film oder diese Filme sichtbar sind; und
C2) Zusammenfügen der dicken Folie mit dem Film oder den mehreren Filmen oder jedes ausgestanzten Kartenkörpers mit einem der Filme.

10. Verfahren nach Anspruch 9, **dadurch gekennzeichnet, dass** nach dem Druckschritt B) und vor dem Schritt C) vorgesehen ist, die erste gedruckte Fläche mit einem Schutzfilm oder mit einem Lack zu überziehen, derart, dass die gedruckten ersten Muster geschützt sind.

11. Verfahren nach Anspruch 10, **dadurch gekennzeichnet, dass** der Schutzfilm oder der Lack ablösbar auf der ersten gedruckten Fläche der dicken Folie angeordnet sind und vor dem Schritt C) abgezogen werden.

12. Verfahren nach Anspruch 9 oder 11, **dadurch gekennzeichnet, dass** eine dünne Harzschicht entweder auf die erste bedruckte Fläche der dicken Folie oder auf die bedruckte Fläche des Films oder der Filme aufgebracht wird, wobei diese dünne Harzschicht in der Weise gewählt ist, dass eine Haftungsgrenzfläche zwischen diesem Film oder diesen Filmen und der dicken Folie gebildet wird.

13. Verfahren nach Anspruch 10, **dadurch gekennzeichnet, dass** der Schutzfilm oder der Lack eine Schicht der Karten bilden und in der Weise gewählt sind, dass eine Haftungsgrenzfläche zwischen dem Film oder den Filmen und der dicken Folie oder den ausgestanzten Kartenkörpern gebildet wird.

14. Verfahren nach einem der Ansprüche 9 bis 13, **dadurch gekennzeichnet, dass** die Schritte B) und C) an unterschiedlichen Produktionsorten ausgeführt werden.

15. Verfahren nach einem der Ansprüche 9 bis 14, **dadurch gekennzeichnet, dass** das erste Muster einen Basissicherheitsdruck definiert und dass das zweite Muster einen personalisierten Druck definiert.

16. Verfahren nach Anspruch 15, **dadurch gekennzeichnet, dass** der personalisierte Druck einen Druck erfordert, der eine geringere Auflösung als der Sicherheitsdruck aufweist.

17. Verfahren nach Anspruch 15 oder 16, **dadurch gekennzeichnet, dass** der Basissicherheitsdruck ein Druck mit hoher Auflösung ist, der insbesondere Druckelemente enthalten kann, die für das bloße Auge nahezu nicht wahrnehmbar sind.

18. Verfahren nach einem der Ansprüche 9 bis 14, **dadurch gekennzeichnet, dass** der Film oder die Filme mit der dicken Folie oder den ausgestanzten Kartenkörpern durch einen geringen Eintrag an Wärmeenergie oder ohne Wärmeeintrag laminiert werden.

19. Verfahren nach einem der Ansprüche 9 bis 18, **dadurch gekennzeichnet, dass** die Druckanlage aus mehreren Zylindern gebildet ist, die als Druckträger dienen, wobei die dicke Folie, in die die mehreren elektronischen Einheiten eingearbeitet sind, im Druckschritt nacheinander auf der Oberfläche dieser Zylinder angeordnet werden und somit in dieser Druckanlage mehrmals gekrümmt werden.

20. Verfahren nach Anspruch 19, **dadurch gekennzeichnet, dass** die Druckanlage eine Offsetdruckanlage oder dergleichen ist, die die Verwirklichung von Drucken mit hoher Auflösung ermöglicht.

21. Verfahren nach einem der Ansprüche 9 bis 20, **dadurch gekennzeichnet, dass** außerdem vorgesehen ist, einen Druck mehrerer vierter Muster auf einem zweiten wenigstens teilweise transparenten Film auszuführen und diesen zweiten Film der zweiten Fläche der dicken Folie zuzuführen, derart, dass sich die bedruckte Fläche dieses Films auf Seiten dieser dicken Folie befindet, wobei sich jedes vierte Muster über einem anderen Kartenkörper befindet.

22. Zwischenprodukt, das bei der Fertigung elektronischer Karten auftritt, **dadurch gekennzeichnet, dass** es durch eine Folie gebildet ist, in die mehrere elektronische Einheiten eingearbeitet sind und die mehrere jeweilige Kartenkörper definiert, wobei diese Folie auf Seiten einer ersten Fläche mehrere erste Muster aufweist, die mit einer Tinte gedruckt sind und die jeweils einem anderen Kartenkörper zugeordnet sind.

23. Zwischenprodukt nach Anspruch 22, **dadurch gekennzeichnet, dass** die mehreren ersten Muster mit einer Schutzbeschichtung, insbesondere mit einem plastischen Film, einer Harzschicht oder einem Lack überzogen sind.

24. Zwischenprodukt nach Anspruch 23, **dadurch gekennzeichnet, dass** die Schutzbeschichtung ablösbar auf der ersten Fläche der Folie angeordnet ist.

25. Zwischenprodukt nach Anspruch 23, **dadurch gekennzeichnet, dass** die Schutzbeschichtung fest auf der Folie haftet und dazu bestimmt ist, eine Schicht der Karten zu bilden, die ausgehend von diesem Zwischenprodukt gefertigt werden.

26. Zwischenprodukt nach einem der Ansprüche 22 bis 25, **dadurch gekennzeichnet, dass** die ersten Muster Sicherheitsmuster definieren.

27. Zwischenprodukt nach einem der Ansprüche 22 bis 25, **dadurch gekennzeichnet, dass** die Folie auf Seiten der zweiten Fläche mehrere zweite gedruckte Muster aufweist, die jeweils einem anderen Kartenkörper zugeordnet sind.

28. Platte, die mehrere Karten bildet und eine dicke Folie oder Schicht umfasst, in die mehrere elektronische Einheiten eingearbeitet sind, wobei diese dicke Folie oder Schicht mehrere jeweilige Kartenkörper definiert und eine erste Fläche mit mehreren ersten Mustern, die mit einer Tinte gedruckt sind, aufweist, wobei diese Platte außerdem einen wenigstens teilweise transparenten Film aufweist, der auf der ersten Fläche der dicken Folie oder Schicht angeordnet ist und auf seiner inneren Fläche mehrere zweite gedruckte Muster aufweist, wobei jeder Kartenkörper einem ersten Muster und einem zweiten Muster zugeordnet ist, die sich im Wesentlichen auf demselben Niveau der Karte befinden.

29. Platte nach Anspruch 28, **dadurch gekennzeichnet, dass** die mehreren ersten Muster und die mehreren zweiten Muster voneinander durch eine wenigstens teilweise transparente dünne Schicht, die eine Haftungsgrenzfläche bildet, getrennt sind.

30. Platte nach Anspruch 28 oder 29, **dadurch gekennzeichnet, dass** die ersten Muster Sicherheitsmuster mit hoher Auflösung definieren und die zweiten Muster wenigstens einen Teil persönlicher Daten definieren.

31. Platte nach einem der Ansprüche 28 bis 30, **dadurch gekennzeichnet, dass** die ersten Muster in einer Druckanlage des Offsettyps oder dergleichen gedruckt sind.

32. Platte nach einem der Ansprüche 28 bis 31, **dadurch gekennzeichnet, dass** sie auf Seiten der zweiten Fläche wenigstens mehrere dritte gedruckte Muster aufweist, die durch eine wenigstens teilweise transparente Beschichtung geschützt sind.
